# EUROPEAN PATENT APPLICATION

(11) **EP 4 553 198 A1**
(43) Date of publication of application: **14.05.2025**
(21) Application number: 24211088.0
(22) Date of filing: 06.11.2024
(51) Int. Cl.: C30B 23/02, C30B 29/36

(54) **SIC EPITAXIAL WAFER**

(30) Priority: 07.11.2023 JP 2023190351; 05.11.2024 JP 2024193689
(71) Applicant: Resonac Corporation, Tokyo 105-7325 (JP)
(72) Inventor: UMETA, Yoshikazu, Tokyo, 105-7325 (JP); OHUCHI, Marie, Tokyo, 105-7325 (JP)
(74) Representative: Strehl & Partner mbB

(57) **Abstract**

An objective of the present invention is to provide a SiC epitaxial wafer with a large diameter, a low triangular defect density, and high carrier concentration uniformity. According to the present invention, a SiC epitaxial wafer includes a SiC substrate and a SiC epitaxial layer. The SiC substrate has a diameter of 195 mm or more. The SiC epitaxial layer has a triangular defect density of 0.2 pieces/cm² or less and a carrier concentration variation of 20% or less.

## Description

### BACKGROUND OF THE INVENTION

### Field of the Invention

The present invention relates to a SiC epitaxial wafer.

Priority is claimed on Japanese Patent Application No. 2023-190351, filed November 7, 2023 and Japanese Patent Application No. 2024-193689, filed November 5, 2024, the content of which is incorporated herein by reference.

### Description of Related Art

Silicon carbide (SiC) has a dielectric breakdown field that is ten times larger than that of silicon (Si) and has a band gap that is three times larger than that of silicon (Si). Moreover, silicon carbide (SiC) has a characteristic such as thermal conductivity that is three times higher than that of silicon (Si). For this reason, silicon carbide (SiC) is expected to be applied to power devices, high-frequency devices, high-temperature operation devices, and the like. Thus, in recent years, SiC epitaxial wafers have been used for the semiconductor devices as described above.

SiC epitaxial wafers are obtained by stacking a SiC epitaxial layer on the surface of a SiC substrate. Hereinafter, a substrate before the SiC epitaxial layer is stacked will be referred to as a SiC substrate, and a substrate after the SiC epitaxial layer is stacked will be referred to as a SiC epitaxial wafer. The SiC substrate is produced by cutting out the SiC substrate from the SiC ingot. SiC devices such as a power device, a high-frequency device, and a high-temperature operating device are obtained by forming a device on the SiC epitaxial layer of the SiC epitaxial wafer and then chipping the SiC epitaxial wafer.

One index for evaluating SiC epitaxial wafers is a carrier concentration. To increase the uniformity of chips acquired from one SiC epitaxial wafer, the carrier concentration in the plane of the SiC epitaxial wafer is preferably uniform. For example, Patent Documents 1 and 2 disclose a SiC epitaxial wafer having the high uniformity of the carrier concentration in the plane. Moreover, Patent Document 3 discloses a SiC epitaxial growth device capable of increasing temperature uniformity during a manufacturing process that affects the uniformity of the carrier concentration in the plane.

### [Patent Documents]

[Patent Document 1] Japanese Patent No. 6969628
[Patent Document 2] Japanese Unexamined Patent Application, First Publication No. 2017-84989
[Patent Document 3] Japanese Unexamined Patent Application, First Publication No. 2019-96764

### SUMMARY OF THE INVENTION

To increase the number of SiC devices that can be acquired from a single SiC epitaxial wafer, a larger diameter of the SiC epitaxial wafer is required. However, it is not easy to increase the diameter of the SiC epitaxial wafer.

As SiC epitaxial wafers become larger in diameter, the thermal stress applied to manufactured components and substrates increases. Large thermal stresses cause large deformation of parts and cause dust generation. When particles are deposited on the SiC substrate, defects occur in the SiC epitaxial wafer. To suppress defects in SiC epitaxial wafers, it is also conceivable to reduce the size of a SiC epitaxial growth device and reduce the thermal stress applied to the parts. However, if the size of the SiC epitaxial growth device is small, it becomes difficult to increase the uniformity of the SiC epitaxial wafer in the plane. That is, as the diameter of the SiC epitaxial wafer increases, the achievement of both a low defect density and a high degree of uniformity in the plane becomes difficult.

The present invention has been made in view of the above-described problems and an objective of the present invention is to provide a SiC epitaxial wafer with a large diameter, a low triangular defect density, and high carrier concentration uniformity.
(1) According to a first aspect, there is provided a SiC epitaxial wafer including a SiC substrate; and a SiC epitaxial layer, wherein the SiC substrate has a diameter of 195 mm or more, and wherein the SiC epitaxial layer has a triangular defect density of 0.2 pieces/cm² or less and a carrier concentration variation of 20% or less.
(2) In the SiC epitaxial wafer according to the above-described aspect, the SiC epitaxial layer can be divided into a plurality of regions each having a 5 mm square in a planar view in a stacking direction of the SiC epitaxial wafer, and a proportion of a region not having a triangular defect among the plurality of regions may be 98% or more.
(3) In the SiC epitaxial wafer according to the above-described aspect, the SiC epitaxial layer may have a carrier concentration variation of 20% or less in a first region at a distance of 60 mm or more and 95 mm or less from a center of the SiC epitaxial layer in a planar view in a stacking direction of the SiC epitaxial wafer.
(4) In the SiC epitaxial wafer according to the above-described aspect, a variation in a film thickness of the SiC epitaxial layer may be 5% or less.
(5) In the SiC epitaxial wafer according to the above-described aspect, the SiC epitaxial layer may have the film thickness variation of 5% or less in a first region at a distance of 60 mm or more and 95 mm or less from a center of the SiC epitaxial layer in a planar view in a stacking direction of the SiC epitaxial wafer.

According to the above-described aspects, a SiC epitaxial wafer has a large diameter, a low triangular defect density, and high carrier concentration uniformity.

### BRIEF DESCRIPTION OF THE DRAWINGS

FIG. 1 is a cross-sectional view of a SiC epitaxial wafer according to the present embodiment.
FIG. 2 is a plan view of the SiC epitaxial wafer according to the present embodiment.
FIG. 3 is a cross-sectional view for describing a triangular defect according to the present embodiment.
FIG. 4 is a plan view of a triangular defect according to the present embodiment.
FIG. 5 is a diagram in which a portion around the center of the SiC epitaxial wafer according to the present embodiment is enlarged.
FIG. 6 is a cross-sectional view of a SiC epitaxial wafer manufacturing device according to the present embodiment.

### DETAILED DESCRIPTION OF THE INVENTION

Hereinafter, a SiC epitaxial wafer and the like according to the present embodiments will be described in detail with reference to the drawings as appropriate. In the drawings used in the following description, featured parts may be enlarged for convenience such that the features of the present invention are easier to understand, and dimensional ratios and the like of the respective components may be different from actual ones. Materials, dimensions, and the like exemplified in the following description are examples, the present invention is not limited thereto, and modifications can be appropriately made without departing from the subject matter of the present invention.

As used herein, an individual direction is denoted by [] and a group direction is denoted by <>. For negative indices, a "-" (bar) placed above the number is customary in crystallography, but a negative sign is placed before the number in this specification.

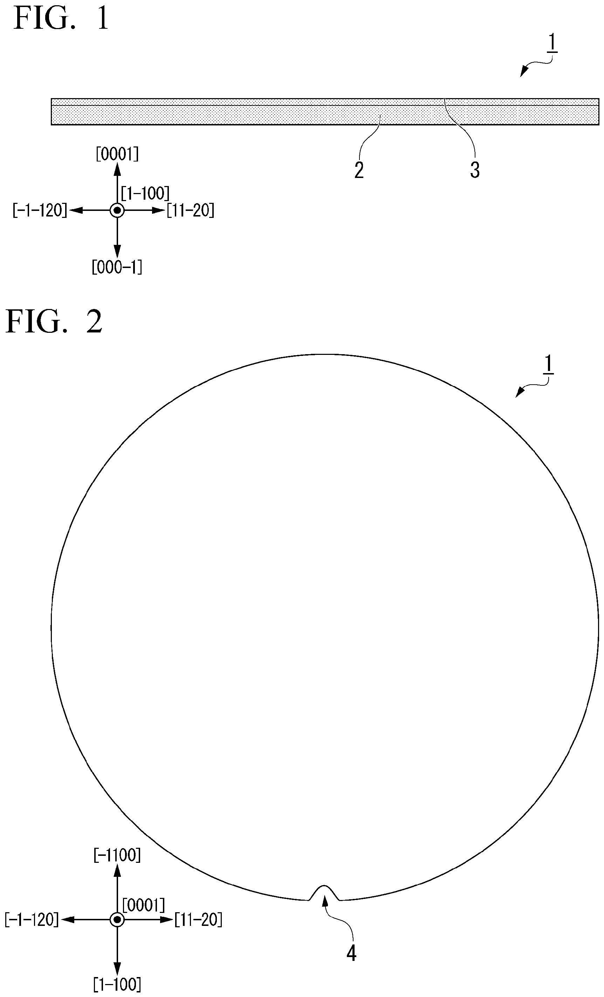

FIG. 1 is a cross-sectional view of a SiC epitaxial wafer 1 according to the present embodiment. FIG. 2 is a plan view of the SiC epitaxial wafer 1 according to the present embodiment.

The SiC epitaxial wafer 1 includes a SiC substrate 2 and a SiC epitaxial layer 3. A planar shape of the SiC epitaxial wafer 1 is approximately circular. The SiC epitaxial wafer 1 may have a notch 4 for ascertaining a direction of a crystal axis. Moreover, the SiC epitaxial wafer 1 may have an orientation flat instead of the notch 4.

The SiC epitaxial wafer 1 is a wafer of 8 inches (approximately 200 mm) or more. A diameter of the SiC epitaxial wafer 1 is 195 mm or more, preferably 199 mm or more. Moreover, the diameter of the SiC epitaxial wafer 1 is preferably 205 mm or less, more preferably 201 mm or less.

The diameter of the SiC epitaxial wafer may be measured using the laser displacement meter.

The SiC substrate 2 is made of, for example, n-type SiC. A polytype of the SiC substrate 2 may be any of 2H, 3C, 4H, or 6H regardless of particular preference. The SiC substrate 2 is, for example, 4H-SiC. A diameter of the SiC substrate 2 is the same as a diameter of the SiC epitaxial wafer 1.

The SiC epitaxial layer 3 is stacked on one side of the SiC substrate 2. The SiC epitaxial layer 3 is made of SiC.

In the SiC epitaxial layer 3 according to the present embodiment, a triangular defect density is 0.2 pieces/cm² or less. A triangular defect density in the SiC epitaxial layer 3 is preferably 0.1 pieces/cm² or less, more preferably 0.05 pieces/cm² or less, even more preferably 0.03 pieces/cm² or less, and particularly preferably 0.01 pieces/cm² or less. A lower limit of the triangular defect density in the SiC epitaxial layer 3 may be 0.003 pieces/cm². The lower limit of the triangular defect density in the SiC epitaxial layer 3 may be 0 pieces/cm².

The triangular defect density may be obtained by observing the triangular defect in the field of view, and measuring the triangular defect density, using an optical microscope (a product name of SICA88 manufactured by Lasertec Corporation).

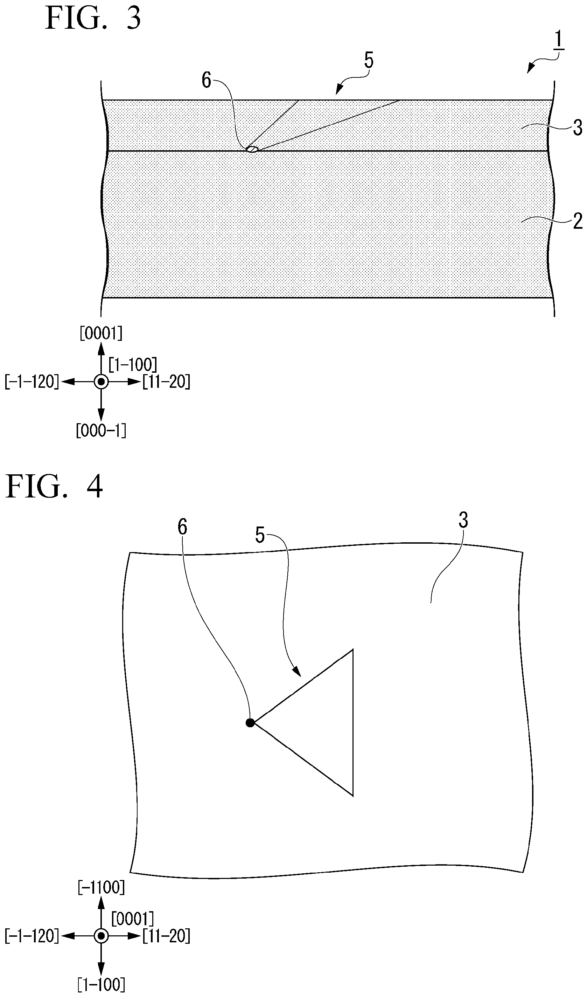

The triangular defect is a defect that appears to be triangular when the surface of the SiC epitaxial layer 3 is observed using an optical microscope. FIGS. 3 and 4 are explanatory diagrams showing the triangular defect. A triangular defect 5 extends from a starting point 6 in a step flow growth direction. The triangular defect 5 is formed in a direction in which a vertex of the triangle and its opposite side (a bottom) are arranged in order in the step flow growth direction. The starting point 6 is, for example, a particle, damage such as a scratch on the SiC substrate 2, a two-dimensional nucleus formed on a terrace during step flow growth, a crystal nucleus of a heterogeneous polytype, a penetrating spiral dislocation (TSD), or the like.

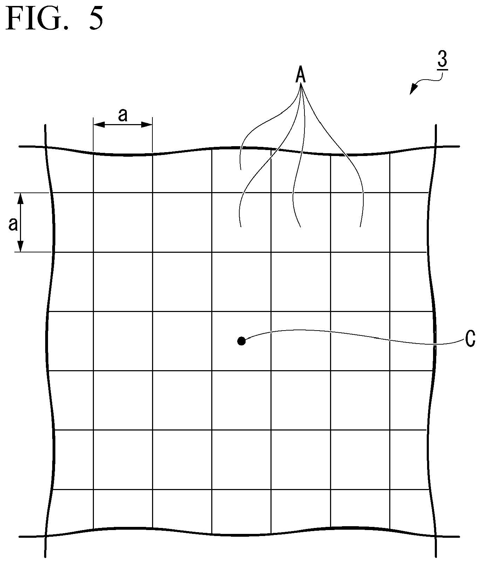

The SiC epitaxial layer 3 can be divided into a plurality of regions A in a planar view in a stacking direction of the SiC epitaxial wafer (a <0001> direction). FIG. 5 is an example in which the SiC epitaxial wafer according to the present embodiment is divided into a plurality of regions A. Each of the regions A is a square with a side length a. The regions A are laid on the surface of the SiC epitaxial layer 3 without any gaps. A center of one of the plurality of regions A coincides with a center C of the SiC epitaxial layer 3. Each of the regions A corresponds to one of the chips to be individually partitioned, and each region is a SiC device.

For example, when the SiC epitaxial layer 3 is divided into a plurality of regions A having a side length a of 5 mm, the proportion of the region that does not have the triangular defect 5 is preferably 98% or more. In this case, an upper limit of the proportion of the region that does not have the triangular defect 5 may be 99% or 100%. The upper limit of the proportion of the region that does not have the triangular defect 5 may be 99.97%.

For example, when the SiC epitaxial layer 3 is divided into a plurality of regions A having a side length a of 7 mm, the proportion of the region that does not have the triangular defect 5 is preferably 95% or more and more preferably 98% or more. In this case, an upper limit of the proportion of the region that does not have the triangular defect 5 may be 99% or 100%. The upper limit of the proportion of the region that does not have the triangular defect 5 may be 99.97%.

For example, when the SiC epitaxial layer 3 is divided into a plurality of regions A having a side length a of 10 mm, the proportion of the region that does not have the triangular defect 5 is preferably 88% or more, more preferably 95% or more, and even more preferably 98% or more. In this case, an upper limit of the proportion of the region that does not have the triangular defect 5 may be 99% or 100%. The upper limit of the proportion of the region that does not have the triangular defect 5 may be 99.97%.

For example, when the SiC epitaxial layer 3 is divided into a plurality of regions A having a side length a of 15 mm, the proportion of the region that does not have the triangular defect 5 is preferably 75% or more, more preferably 88% or more, even more preferably 95% or more, and particularly preferably 98% or more. In this case, an upper limit of the proportion of the region that does not have the triangular defect 5 may be 99% or 100%. The upper limit of the proportion of the region that does not have the triangular defect 5 may be 99.97%.

For example, when the SiC epitaxial layer 3 is divided into a plurality of regions A having a side length a of 20 mm, the proportion of the region that does not have the triangular defect 5 is preferably 60% or more, more preferably 75% or more, even more preferably 88% or more, more preferably 95% or more, and still more preferably 98% or more. In this case, an upper limit of the proportion of the region that does not have the triangular defect 5 may be 99% or 100%. The upper limit of the proportion of the region that does not have the triangular defect 5 may be 99.97%.

The proportion of the region that does not have the triangular defect 5 in the SiC epitaxial layer 3 may be calculated by a general formula (1): the proportion of the region that does not have the triangular defect = { 1 - (a number of square regions A that has the triangular defect/a total number of square regions A)}×100. In the general formula (1), the total number of square regions A may be obtained by dividing the entire plane of the SiC epitaxial layer 3 into a plurality of non-overlapping square regions A in which a side length a is a specific value, aligned without gaps, using an optical microscope (a product name of S1CA88 manufactured by Lasertec Corporation) and counting the number of the square regions A. The number of square regions A that has the triangular defect may be obtained by counting the number of square regions A that has the triangular defect in the entire plane of the SiC epitaxial layer 3 using the optical microscope.

If the density of triangular defects 5 in the SiC epitaxial layer 3 is 0.2 pieces/cm² or less, a sufficient proportion of the region that does not have the triangular defect 5 can be achieved. Because the plurality of regions A correspond to chips serving as devices, if the above-described proportion is satisfied, SiC devices can be acquired at a high yield from the SiC epitaxial wafer 1 according to the present embodiment. Moreover, as the side length a increases, a SiC device that can withstand the application of a large electric current can be acquired.

Moreover, in the SiC epitaxial layer according to the present embodiment, a variation in the carrier concentration is 20% or less, preferably 15% or less, more preferably 12% or less, even more preferably 10% or less, particularly preferably 5% or less, and particularly more preferably 2% or less.

A lower limit value of the variation in the carrier concentration in the SiC epitaxial layer may be 0.5% or 1.5%.

The variation in the carrier concentration is obtained by dividing a difference between a maximum value and a minimum value of the carrier concentration of the SiC epitaxial layer 3 measured along a straight line extending in a <11-20> direction through the center C of the SiC epitaxial layer 3 by a value obtained by multiplying the average value by 2. The carrier concentration may be measured at equal intervals from the center C on a straight line or the interval may change. The carrier concentration may be measured at 10 mm intervals, 15 mm intervals, 20 mm intervals, 25 mm intervals, or 30 mm intervals.

For example, when the diameter of the SiC epitaxial wafer 1 is 200 mm (8 inches), the carrier concentration is measured at the center and positions of ±20 mm, ±40 mm, ±60 mm, ±80 mm, and ±95 mm from the center along a straight line L extending in the <11-20> direction with the center C as the reference. Carrier concentration uniformity is obtained from carrier concentrations at these measurement points.

Moreover, for example, when the diameter of the SiC epitaxial wafer 1 is 250 mm (10 inches), the carrier concentration is measured at the center and positions of ±25 mm, ±50 mm, ±75 mm, ±100 mm, and ±120 mm from the center along the straight line L extending in the <11-20> direction with the center C as the reference. Carrier concentration uniformity is obtained from carrier concentrations at these measurement points.

Moreover, for example, when the diameter of the SiC epitaxial wafer 1 is 300 mm (12 inches), the carrier concentration is measured at the center and positions of ±30 mm, ±60 mm, ±90 mm, ±120 mm, and ±145 mm from the center along the straight line L extending in the <11-20> direction with the center C as the reference. Carrier concentration uniformity is obtained from carrier concentrations at these measurement points.

Here, the carrier concentration is an effective carrier concentration. The effective carrier concentration is an absolute value of a difference between a donor concentration and an acceptor concentration. The carrier concentration of the SiC epitaxial layer 3 can be measured by, for example, a mercury probe (Hg-CV) method or a secondary ion mass spectrometry (SIMS) method. In the Hg-CV method, a difference between the donor concentration and the acceptor concentration is measured as the effective carrier concentration. The secondary ion mass spectrometry (SIMS) method is a method of performing ejected secondary ion mass spectrometry while scraping the layer in a thickness direction. Doping concentrations can be measured from mass spectrometry. In the secondary ion mass spectrometry (SIMS) method, it is possible to measure actual values of the donor concentration and the acceptor concentration and find the effective carrier concentration by finding a difference therebetween.

In the first region at a distance of 60 mm or more and 95 mm or less from the center C in the planar view in the stacking direction of the SiC epitaxial wafer, the variation in the carrier concentration of the SiC epitaxial layer 3 is preferably 20% or less, more preferably 15% or less, even more preferably 12% or less, still more preferably 10% or less, particularly preferably 5% of less, and particularly more preferably 2% or less.

A lower limit value of the variation in the carrier concentration in the first region may be 0.5% or 1.5%.

The first region is located on an outer peripheral side of the SiC epitaxial wafer 1 and is a portion where the carrier concentration is likely to vary. If the variation in the portion is within the above-described range, the element variation of the SiC device after a device generation process can be further reduced. The carrier concentration in the first region, for example, is measured at points of ±60 mm, ±80 mm, and ±95 mm from the center along the straight line extending in the <11-20> direction with the center C as the reference and measured at points of ±60 mm, ±80 mm, ±95 mm, and -90 mm from the center along the straight line extending in a <-1100> direction with the center C as the reference. A point of -90 mm is arranged on the inside to avoid the notch 4. In addition, the [11-20] direction or the [-1100] direction is denoted by "+."

Moreover, in the SiC epitaxial layer 3 according to the present embodiment, a variation in the film thickness may be 5% or less. The variation in the film thickness of the SiC epitaxial layer 3 is preferably 4% or less, more preferably 3% or less, even more preferably 2% or less, and particularly preferably 1% or less.

A lower limit value of the variation in the film thickness of the SiC epitaxial layer 3 may be 0.3% or 0.9%.

The variation in the film thickness is obtained by dividing a difference between a maximum value and a minimum value of the film thickness of the SiC epitaxial layer 3 measured using the infrared spectrometric method along a straight line extending in the <11-20> direction through the center C of the SiC epitaxial layer 3 by a value obtained by multiplying the average value by 2. The measurement point of the film thickness is similar to the measurement point of the carrier concentration.

In the first region at a distance of 60 mm or more and 95 mm or less from the center C in the planar view in the stacking direction of the SiC epitaxial wafer, the variation in the film thickness of the SiC epitaxial layer 3 is preferably 5% or less, more preferably 4% or less, even more preferably 3% or less, still more preferably 2% or less, and particularly preferably 1 % or less.

In the first region, a lower limit value of the variation in the film thickness of the SiC epitaxial layer 3 may be 0.3% or 0.9%.

The first region is located on an outer peripheral side of the SiC epitaxial wafer 1 and is a portion where the film thickness is likely to vary. If a variation in the portion is within the above-described range, a variation in the element of the SiC device after a device generation process can be further reduced.

Next, a method of manufacturing the SiC epitaxial wafer 1 according to the present embodiment will be described.

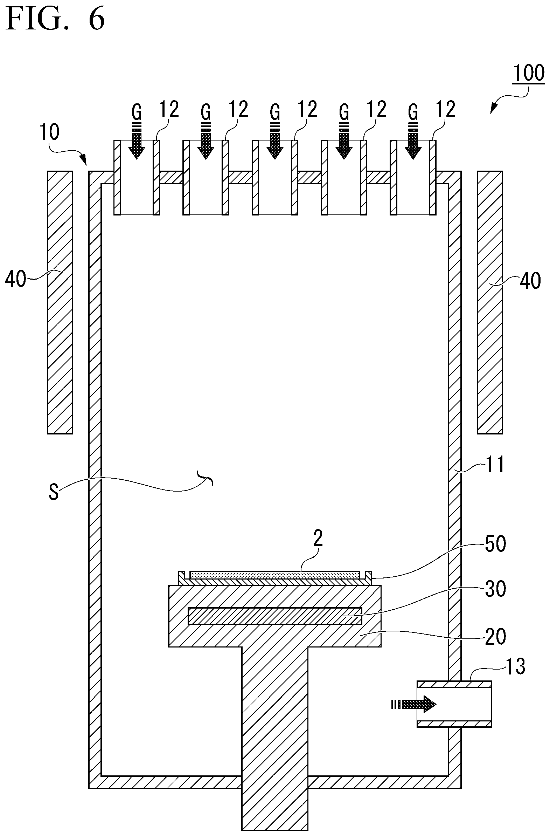

FIG. 6 is a cross-sectional schematic diagram of an example of a film formation device for a SiC epitaxial wafer according to the present embodiment. The film formation device 100 includes, for example, a chamber 10, a support 20, a lower heater 30, and an upper heater 40. The SiC substrate 2 is placed on a susceptor 50 and transported into a film formation device.

The support 20 supports the susceptor 50. The support 20, for example, can be rotated about an axis. The SiC substrate 2 is arranged on the support 20, for example, in a state in which the SiC substrate 2 is placed on the susceptor 50. The lower heater 30, for example, is in the support 20 and heats the SiC substrate 2. The upper heater 40 heats the upper part of the chamber 10.

The chamber 10 includes, for example, a main body 11, a gas supply port 12, and a gas exhaust port 13. The main body 11 surrounds a film formation space S. The gas supply port 12 is an inlet for supplying gas G to the film formation space S. The plurality of gas supply ports 12, for example, are located above a placement surface of the SiC substrate 2. The film formation device in which the gas supply port 12 is located above the placement surface of the SiC substrate 2 is referred to as a vertical furnace. The gas exhaust port 13 is an outlet for exhausting gas G or the like accumulated in the film formation space S. The gas exhaust port 13, for example, is located below the placement surface of the SiC substrate 2.

A distance between the inner surface of the chamber 10 and the SiC substrate 2 is set to 100 mm or more and 800 mm or less. By securing a distance between the inner surface of the chamber 10 and the SiC substrate 2, the generation of the triangular defect 5 caused by particles from the chamber 10 can be suppressed. Moreover, a distance between the inner surface of the chamber 10 and the SiC substrate 2 is secured, and therefore a gas that is not a source gas, such as hydrogen or argon, can easily flow outside of a source gas supply unit (near the inner surface of the chamber 10). When a gas that is not a source gas of 5% or more of a total amount of gas introduced into the furnace flows near the inner surface of the chamber 10, it is possible to suppress the adhesion of the source gas to an inner wall of the chamber 10. The source gas adhering to the inner wall generates a particle-like by-product and can cause the occurrence of the triangular defect 5. Moreover, a distance between the inner surface of the chamber 10 and the SiC substrate 2 is less than or equal to a certain distance, and therefore the input source gas can be efficiently supplied to the SiC substrate 2, and the consumption of the source gas per film thickness can be suppressed. As a result, costs can be reduced.

The gas G is, for example, a source gas, a carrier gas, a dopant gas, and an etching gas. The source gas includes a Si-based source gas and a C-based source gas.

The Si-based source gas is a source gas containing Si in the molecule. Examples of the Si-based source gas include silane (SiH₄), dichlorosilane (SiH₂Cl₂), trichlorosilane (SiHCl₃), tetrachlorosilane (SiCl₄), and the like. The Si-based source gas preferably includes at least one selected from the group consisting of, for example, SiH₃Cl, SiH₂Cl₂, and SiHCl₃.

The C-based source gas is a source gas containing C in the molecule. Examples of the C-based source gas are propane (C₃H₈) and ethylene (C₂H₄). The C-based source gas preferably includes, for example, at least one selected from the group consisting of CH₄, C₂H₆, and C₃H₈.

A dopant gas is a gas containing a carrier element. The dopant gas preferably contains, for example, at least one of nitrogen (N₂) and ammonia (NH₃).

The carrier gas is a gas that conveys the source gas to the SiC substrate 2, and is a gas that is inert to SiC. The carrier gas preferably contains, for example, Ar.

An etching gas is a gas that reacts with SiC at a high temperature and has the action of etching SiC. The etching gas is preferably, for example, hydrogen chloride (HCl).

In the film formation step, the SiC epitaxial layer 3 is formed on the SiC substrate 2. The SiC epitaxial layer is formed by supplying a mixed gas including a Si-based source gas, a C-based source gas, an etching gas, a carrier gas, and a dopant gas to one surface of the SiC substrate 2. When these mixed gases are supplied, a gas with a heavy molecular weight is locally unevenly distributed and exhausted from some gas supply ports 12 among the plurality of gas supply ports 12. Hereinafter, the gas supply port 12 from which the heavy molecular weight gas is exhausted is referred to as a first gas supply port.

A gas with a heavy molecular weight is a gas with a molecular weight of 28 or more, and is, for example, Ar. A process of locally unevenly distributing and exhausting a gas with a heavy molecular weight is implemented by combining first gas supply ports among the plurality of gas supply ports 12 within a certain range. The first gas supply ports among the plurality of gas supply ports 12 are arranged in the central portion.

An area of a portion to which the first gas supply ports belong is set to 0.3% or more and 2.5% or less of an area of a top plate of the chamber 10. The area of the portion to which the first gas supply ports belong is an area surrounded by a line connecting first gas supply ports located at outermost positions. Moreover, a total supply port area of the first gas supply ports is set to 10% or more and 30% of less of a total supply port area of the plurality of gas supply ports 12.

A flow rate of a gas with a heavy molecular weight supplied from the first gas supply port is set to 1000 sccm or more and 4000 sccm or less.

When a gas with a heavy molecular weight is unevenly distributed and supplied at a predetermined flow rate, a gas G is convected in the film formation space S. Although the gas G passes from the gas supply port 12 to the surface of the SiC substrate 2 and forms a flow toward the gas exhaust port 13 in general, a variation in a carrier concentration of the SiC epitaxial layer 3 can be suppressed by deliberately allowing the gas G to convect. Moreover, it is possible to suppress the variation in the film thickness of the SiC epitaxial layer 3 by convection of the gas G.

As described above, it is possible to obtain a SiC epitaxial wafer 1 with a large diameter, a low triangular defect density, and high carrier concentration uniformity by controlling the flow of the gas G in the film formation space S and preventing particles from adhering to the SiC substrate 2.

The SiC epitaxial wafer 1 according to the present embodiment has few triangular defects and high carrier density uniformity in the plane despite the large diameter. Therefore, from the SiC epitaxial wafer 1 according to the present embodiment, a SiC device that is a good product can be obtained at a high yield.

Although modes for carrying out the present invention have been described using embodiments, the present invention is not limited to the embodiments and various modifications and substitutions can also be made without departing from the scope and spirit of the present invention.

### [Inventive examples]

### "Inventive example 1"

First, a 4H-SiC substrate having a diameter of 203 mm was provided and housed inside a vertical furnace as shown in FIG. 6. The SiC substrate 2 was placed on the susceptor 50 and housed in the chamber 10 together with the susceptor 50. The distance between the SiC substrate 2 and the inner wall of the chamber 10 was 100 mm or more to suppress the adhesion of particles to the SiC substrate 2.

Next, a SiC epitaxial layer 3 having a thickness of 11 µm was formed on the SiC substrate 2. The carrier gas was Ar.

A ratio of the area of the part belonging to the carrier gas supply port (first gas supply port) to the top plate of the chamber: 2%

A ratio of the area of the carrier gas supply ports (the first gas supply ports) to all gas supply ports: 20%

A flow rate of the carrier gas was 1000 sccm or more and 4000 sccm or less.

The triangular defect density, the variation in the carrier concentration, and the variation in the film thickness of the SiC epitaxial wafer produced under the above conditions were measured.

The triangular defect density was measured using an optical microscope (a product name of S1CA88 manufactured by Lasertec Corporation).

The proportion of the region that does not have the triangular defect in the SiC epitaxial layer was calculated by the general formula (1): the proportion of the region that does not have the triangular defect = {1 - (a number of square regions A that has the triangular defect/a total number of square regions A)}×100. In the general formula (1), the total number of square regions A was obtained by dividing the entire plane of the SiC epitaxial layer into the plurality of non-overlapping square regions A in which the side length a is 5 mm, aligned without gaps, using the optical microscope (a product name of SICA88 manufactured by Lasertec Corporation) and counting the number of the square regions A. The number of square regions A that has the triangular defect was obtained by counting the number of square regions A that has the triangular defect in the entire plane of the SiC epitaxial layer 3 using the optical microscope.

The carrier concentration was measured using the Hg-CV method. The measurement points were a center and positions of ±20 mm, ±40 mm, ±60 mm, ±80 mm, and ±95 mm from the center along the straight line L extending in the <11-20> direction with the center C as the reference. The variation in the carrier concentration was found from the carrier concentration at each measurement point. Moreover, the variation in the carrier concentration in the first region was also measured. The carrier concentration of the first region was measured at points of ±60 mm, ±80 mm, and ±95 mm from the center along a straight line extending in the <11-20> direction with the center C as the reference and points of ±60 mm, ±80 mm, ±95 nm, and -90 mm from the center along a straight line extending in the <-1100> direction with the center C as the reference.

The variation in the film thickness was measured by infrared spectroscopy. The variation in the film thickness was also measured in the first region. The measurement point of the variation in the film thickness was the same as the measurement point of the carrier concentration.

The triangular defect density of the SiC epitaxial wafer of inventive example 1 was 0.03 pieces/cm². Moreover, the variation in the carrier concentration of the SiC epitaxial wafer of inventive example 1 was 13.4%. Moreover, the variation in the carrier concentration in the first region of the SiC epitaxial wafer of inventive example 1 was 5.1%. Moreover, the variation in the film thickness of the SiC epitaxial layer of the SiC epitaxial wafer of inventive example 1 was 3.1%. Moreover, the variation in the film thickness of the epitaxial layer in the first region of the SiC epitaxial wafer of inventive example 1 was 1.9%. Moreover, when the SiC epitaxial layer was divided into a plurality of regions having a side length of 5 mm, the proportion of the region without triangular defects was 98% or more.

### "Inventive example 2"

First, a 4H-SiC substrate having a diameter of 200 mm was provided and housed inside a vertical furnace as shown in FIG. 6. The SiC substrate 2 was placed on the susceptor 50 and housed in the chamber 10 together with the susceptor 50. The distance between the SiC substrate 2 and the inner wall of the chamber 10 was 100 mm or more to suppress the adhesion of particles to the SiC substrate 2.

Next, a SiC epitaxial layer 3 having a thickness of 11 µm was formed on the SiC substrate 2. The carrier gas was Ar.

A ratio of the area of the part belonging to the carrier gas supply port (first gas supply port) to the top plate of the chamber: 2%

A ratio of the area of the carrier gas supply ports (the first gas supply ports) to all gas supply ports: 15%

A flow rate of the carrier gas was 1000 sccm or more and 4000 sccm or less.

In the SiC epitaxial wafer produced under the above conditions, the triangular defect density, the variation in the carrier concentration, the variation in the carrier concentration in the first region, the variation in the film thickness, the variation in the film thickness in the first region were measured in the same manner as in Inventive example 1. Furthermore, the proportion of the region that does not have the triangular defect in the SiC epitaxial layer was calculated in the same manner as in Inventive example 1.

The triangular defect density of the SiC epitaxial wafer of inventive example 2 was 0.20 pieces/cm². Moreover, the variation in the carrier concentration of the SiC epitaxial wafer of inventive example 2 was 11.8%. Moreover, the variation in the carrier concentration in the first region of the SiC epitaxial wafer of inventive example 2 was 3.7%. Moreover, the variation in the film thickness of the SiC epitaxial layer of the SiC epitaxial wafer of inventive example 2 was 6.5%. Moreover, the variation in the film thickness of the epitaxial layer in the first region of the SiC epitaxial wafer of inventive example 2 was 2.2%. Moreover, when the SiC epitaxial layer was divided into a plurality of regions having a side length of 5 mm, the proportion of the region without triangular defects was 98% or more.

### "Inventive example 3"

First, a 4H-SiC substrate having a diameter of 200 mm was provided and housed inside a vertical furnace as shown in FIG. 6. The SiC substrate 2 was placed on the susceptor 50 and housed in the chamber 10 together with the susceptor 50. The distance between the SiC substrate 2 and the inner wall of the chamber 10 was 120 mm or more to suppress the adhesion of particles to the SiC substrate 2.

Next, a SiC epitaxial layer 3 having a thickness of 11 µm was formed on the SiC substrate 2. The carrier gas was Ar.

A ratio of the area of the part belonging to the carrier gas supply port (first gas supply port) to the top plate of the chamber: 2%

A ratio of the area of the carrier gas supply ports (the first gas supply ports) to all gas supply ports: 20%

A flow rate of the carrier gas was 1000 sccm or more and 4000 sccm or less.

In the SiC epitaxial wafer produced under the above conditions, the triangular defect density, the variation in the carrier concentration, the variation in the carrier concentration in the first region, the variation in the film thickness, the variation in the film thickness in the first region were measured in the same manner as in Inventive example 1. Furthermore, the proportion of the region that does not have the triangular defect in the SiC epitaxial layer was calculated in the same manner as in Inventive

### example 1.

The triangular defect density of the SiC epitaxial wafer of inventive example 3 was 0.05 pieces/cm². Moreover, the variation in the carrier concentration of the SiC epitaxial wafer of inventive example 3 was 12.0%. Moreover, the variation in the carrier concentration in the first region of the SiC epitaxial wafer of inventive example 3 was 11.9%. Moreover, the variation in the film thickness of the SiC epitaxial layer of the SiC epitaxial wafer of inventive example 3 was 5.4%. Moreover, the variation in the film thickness of the epitaxial layer in the first region of the SiC epitaxial wafer of inventive example 3 was 4.3%. Moreover, when the SiC epitaxial layer was divided into a plurality of regions having a side length of 5 mm, the proportion of the region without triangular defects was 98% or more.

### "Inventive example 4"

First, a 4H-SiC substrate having a diameter of 203 mm was provided and housed inside a vertical furnace as shown in FIG. 6. The SiC substrate 2 was placed on the susceptor 50 and housed in the chamber 10 together with the susceptor 50. The distance between the SiC substrate 2 and the inner wall of the chamber 10 was 120 mm or more to suppress the adhesion of particles to the SiC substrate 2.

Next, a SiC epitaxial layer 3 having a thickness of 11 µm was formed on the SiC substrate 2. The carrier gas was Ar.

A ratio of the area of the part belonging to the carrier gas supply port (first gas supply port) to the top plate of the chamber: 2%

A ratio of the area of the carrier gas supply ports (the first gas supply ports) to all gas supply ports: 15%

A flow rate of the carrier gas was 1000 sccm or more and 4000 sccm or less.

In the SiC epitaxial wafer produced under the above conditions, the triangular defect density, the variation in the carrier concentration, the variation in the carrier concentration in the first region, the variation in the film thickness, the variation in the film thickness in the first region were measured in the same manner as in Inventive example 1. Furthermore, the proportion of the region that does not have the triangular defect in the SiC epitaxial layer was calculated in the same manner as in Inventive example 1.

The triangular defect density of the SiC epitaxial wafer of inventive example 4 was 0.02 pieces/cm². Moreover, the variation in the carrier concentration of the SiC epitaxial wafer of inventive example 4 was 9.9%. Moreover, the variation in the carrier concentration in the first region of the SiC epitaxial wafer of inventive example 4 was 7.1%. Moreover, the variation in the film thickness of the SiC epitaxial layer of the SiC epitaxial wafer of inventive example 4 was 4.5%. Moreover, the variation in the film thickness of the epitaxial layer in the first region of the SiC epitaxial wafer of inventive example 4 was 1.2%. Moreover, when the SiC epitaxial layer was divided into a plurality of regions having a side length of 5 mm, the proportion of the region without triangular defects was 98% or more.

### "Comparative example 1"

In comparative example 1, an area ratio of a portion to which carrier gas supply ports (first gas supply ports) belonged to the top plate of the chamber was 42% and an area ratio of the carrier gas supply ports (first gas supply ports) to all gas supply ports was 71%. Moreover, a flow rate of the carrier gas in comparative example 1 was less than the flow rate in inventive example 1 and was less than 1000 sccm.

In a state in which other conditions were the same as those of inventive example 1, the triangular defect density of the SiC epitaxial wafer, the variation in the carrier concentration, and the variation in the film thickness in comparative example 1 were measured.

The triangular defect density of the SiC epitaxial wafer of comparative example 1 was 0.26 pieces/cm². Moreover, the variation in the carrier concentration of the SiC epitaxial wafer of comparative example 1 was 29.35%. Moreover, the variation in the carrier concentration in the first region of the SiC epitaxial wafer of comparative example 1 was 28.8%. Moreover, the variation in the film thickness of the SiC epitaxial layer of the SiC epitaxial wafer of comparative example 1 was 5.15%. Moreover, the variation in the film thickness of the epitaxial layer in the first region of the SiC epitaxial wafer of comparative example 1 was 5.1%. Moreover, when the SiC epitaxial layer was divided into a plurality of regions having a side length of 5 mm, the proportion of the region without triangular defects was less than 98%.

### EXPLANATION OF REFERENCES

1 SiC epitaxial wafer
2 SiC substrate
3 SiC epitaxial layer
4 Notch
5 Triangular defect
6 Starting point
10 Chamber
11 Main body
12 Gas supply port
13 Gas exhaust port
20 Support
30 Lower heater
40 Upper Heater
50 Susceptor
A Region

## Claims

1. A SiC epitaxial wafer comprising:
a SiC substrate; and
a SiC epitaxial layer,
wherein the SiC substrate has a diameter of 195 mm or more, and
wherein the SiC epitaxial layer has a triangular defect density of 0.2 pieces/cm² or less and a carrier concentration variation of 20% or less.

2. The SiC epitaxial wafer according to claim 1,
wherein the SiC epitaxial layer can be divided into a plurality of regions each having a 5 mm square in a planar view in a stacking direction of the SiC epitaxial wafer, and
wherein a proportion of a region not having a triangular defect among the plurality of regions is 98% or more.

3. The SiC epitaxial wafer according to claim 1 or 2, wherein the SiC epitaxial layer has a carrier concentration variation of 20% or less in a first region at a distance of 60 mm or more and 95 mm or less from a center of the SiC epitaxial layer in a planar view in a stacking direction of the SiC epitaxial wafer.

4. The SiC epitaxial wafer according to any one of claims 1 to 3, wherein a variation in a film thickness of the SiC epitaxial layer is 5% or less.

5. The SiC epitaxial wafer according to claim 4, wherein the SiC epitaxial layer has the film thickness variation of 5% or less in a first region at a distance of 60 mm or more and 95 mm or less from a center of the SiC epitaxial layer in a planar view in a stacking direction of the SiC epitaxial wafer.
